# EUROPEAN PATENT APPLICATION

(11) **EP 4 672 265 A1**
(43) Date of publication of application: **31.12.2025**
(21) Application number: 24196158.0
(22) Date of filing: 23.08.2024
(51) Int. Cl.: G21B 1/05, G21B 1/11, H01B 12/00, H01F 6/06

(54) **STELLARATOR WITH PRE-ALIGNED LAYERED SUPERCONDUCTOR MATERIAL**

(30) Priority: 28.06.2024 US 202463665434 P
(71) Applicant: Proxima Fusion GmbH, 81369 München (DE)
(72) Inventor: KUBIE, Martin, San Francisco, CA, 94114 (US)
(74) Representative: Bardehle Pagenberg Partnerschaft mbB Patentanwälte Rechtsanwälte

(57) **Abstract**

A stellarator comprising a non-planar magnetic field coil with a cable as well as a method for providing a cable for a non-planar magnetic field coil in a stellarator is presented.

The cable comprises an inner section (100) comprising multiple layers of superconductor material (200), the multiple layers of superconductor material (200) having a first orientation (210, 210a, 210b, 210c), an outer section (300) surrounding the inner section (100), the outer section (300) having a cross-section (310) with a second orientation (320, 320a, 320b, 320c), wherein the outer section (300) comprises a first conductive material (410) which fixes the first orientation (210, 210a, 210b, 210c), wherein the first orientation (210, 210a, 210b, 210c) changes along a length (50) of the cable (40) with respect to the second orientation (320, 320a, 320b, 320c).

## Description

### FIELD OF THE INVENTION

The present invention relates generally to non-planar magnetic field coils in a stellarator manufactured using multiple layers of superconductor material.

### BACKGROUND

Stellarators are developed for magnetic confinement of plasmas to provide energy based on fusion reactions which occur inside the confined plasma. To provide the magnetic confinement, stellarators require non-planar magnetic field coils with windings of a cable with superconductor material. The superconductor material allows a positive energy balance of the stellarator as the current in the cable has no electrical resistance, thereby avoiding ohmic losses of the cable during operation. Further, the use of superconductor material allows strong magnetic fields which improves the power density of the plasma and thus the power balance of a stellarator.

Recently, the use of layers of superconductor material in stellarator non-planar magnetic coils is investigated. Layers of superconductor materials, for example rare earth barium copper oxide superconductor, ReBCO, tapes show desirable properties such as ease of manufacturing, capability to generate strong magnetic fields, and high temperature superconductivity. However, it is known that layers of superconductor materials can have a strong magnetic field alignment sensitivity for critical current. The present inventors have realized that for this reason, it is highly beneficial to have a capability to align a first orientation of the multiple layers of superconductor material, for example with a magnetic field of the stellarator.

The present inventors have further realized that at the same time, it may be beneficial to have the ability to align a second orientation of a cross-section of an outer section of the cable independently from the first orientation. This independent alignment of the second orientation may facilitate winding of the non-planar magnetic field coils. In other words, a need exists for a cable which separates the mechanical alignment of the cable from the magnetic alignment of the multiple layers of superconductor material inside the cable.

### SUMMARY

An embodiment according to the invention is a stellarator, comprising: a non-planar magnetic field coil including windings of a cable. The cable comprises: an inner section comprising multiple layers of superconductor material, the multiple layers of superconductor material having a first orientation. The cable further comprises an outer section surrounding the inner section, the outer section having a cross-section with a second orientation, wherein the outer section comprises a first conductive material which fixes the first orientation, wherein the first orientation changes along a length of the cable with respect to the second orientation.

This embodiment allows to independently change the first orientation along the length of the cable with respect to the second orientation. This allows to optimize the first orientation as desired, for example based on a magnetic field of the stellarator as explained below. At the same time, the second orientation may be optimized independently from the first orientation. Thus, the second orientation can be optimized according to different criteria, for example to facilitate winding of the non-planar magnetic field coil or in accordance with mechanical requirements of the non-planar magnetic field coil. Orientations like the first orientation and the second orientation may be described as a normal vector. The orientation may be defined in each plane perpendicular to a path parametrization along the length of the cable.

In some embodiments, the first orientation changes along the length of the cable with respect to the second orientation. The first orientation may change along the length of the cable with respect to the second orientation in at least a first region of the cable. In the cable and/or in the first region of the cable and/or in a plurality of regions of the cable the first orientation may change along the length of the cable with respect to the second orientation with one of the following rates of change: between 0.1 rad/m and 4 rad/m, between 0.4 rad/m and 3.6 rad/m, between 0.8 rad/m and 3.2 rad/m, between 1.2 rad/m and 2.8 rad/m, between 1.6 rad/m and 2.4 rad/m, for example 2 rad/m.

In some embodiments, in the cable and/or in the first region of the cable and/or in a plurality of regions of the cable the first orientation may change along the length of the cable with respect to the second orientation with one of the following rates of change: between 0.1 rad/m and 7 rad/m, between 0.7 rad/m and 6.3 rad/m, between 1.4 rad/m and 5.6 rad/m, between 2.1 rad/m and 4.9 rad/m, between 2.8 rad/m and 4.2 rad/m, 3.5 rad/m.

In some embodiments, in the cable and/or in the first region of the cable and/or in a plurality of regions of the cable the first orientation may change along the length of the cable with respect to the second orientation with one of the following rates of change: between 0.5 rad/m and 6 rad/m, between 1 rad/m and 5 rad/m between 2 rad/m and 5 rad/m, between 3 rad/m and 4 rad/m.

In some embodiments, the rate of change is constant in the first region of the cable and/or in a plurality of regions. In other embodiments, the rate of change is a first constant value in a first region of the cable and a second constant value different from the first constant value in a second region of the cable, the second region of the cable different from the first region of the cable. For example, in a first region the rate of change may be 2 rad/m and in a second region of the cable the rate of change may be 3.5 rad/m. In another embodiment, the rate of change varies along the length of the cable, for example in a first region of the cable. For example, the first region of the cable may extend 1 m along the length of the cable and over the distance of 1 m the rate of change may vary from 1 rad/m to 3.5 rad/m. In another embodiment, the rate of change is in a first range in a first region of the cable and in a second range in the second region of the cable. The first rate of change and/or the second rate of change may be selected from the rates of change mentioned above. For example, the first rate of change may be between 0.5 rad/m and 6 rad/m and the second rate of change may be between 0.7 rad/m and 6.3 rad/m. In some embodiments the ratio of the rate of change in the first region to the rate of change in the second region may be between 0.01 and 70, between 0.02 and 60, between 0.025 and 40, between 0.05 and 20, between 0.1 and 10 or 0.2, 0.3, 0.4, 0.5, 0.6, 0.7, 0.8, 1, 2, 3, 4, 5, 6, 7, 8 or 9 and/or the ratio of the length of the first region to the length of the second region may be between 0.01 and 10, between 0.1 and 9, between 0.2 and 8, between 0.3 and 7, between 0.4 and 6, between 0.5 and 7, between 0.6 and 6, between 0.7 and 5, between 0.8 and 4, between 0.9 and 3 or between 1 and 2.

The first orientation along the length of the cable may be determined by a first twist angle defined perpendicular to a direction along the length of the cable.

Determining the first orientation by a first twist angle may have the advantage that a simple description, for example in polar coordinates, of the first orientation may be achieved. The polar coordinates may be defined locally in a plane perpendicular to a path parametrization along the length of the cable. The description in polar coordinates may also allow simplified alignment with a rotation motion only perpendicular to the length of the cable when manufacturing the cable.

The second orientation along the length of the cable may be determined by a second twist angle defined perpendicular to a direction along the length of the cable. The rate of change of the first orientation along the length of the cable with respect to the second orientation may be described by a relative change between the first orientation and the second orientation, for example a difference between the first orientation and the second orientation. In some embodiments, in the cable and/or in the first region of the cable and/or in a plurality of regions of the cable the first orientation may change along the length of the cable with respect to the second orientation with a rate of change described by a difference between the first orientation and the second orientation. The rate of change may have one of the values for the rate of change described above.

The cross-section may enable mechanical alignment of the second orientation. The cross-section may be one or more of the following cross-sections. The cross-sections may be non-circular, rectangular, square, hexagonal, octagonal, polygonal, a polygonal approximation of a circular shape, a polygonal approximation of an elliptical shape, an equiangular polygon, an equilateral polygon, a regular polygon, a convex polygon. Alternatively or in a addition, the cross-sections may be one or more of the following cross-sections: a polygon with the following number of sides: between 3 and 100, between 3 and 50, between 3 and 64, between 3 and 32, between 4 and 16, between 4 and 12, 3, 4, 5, 6, 7, 8, 9, 10, 11, 12; Further, the cross-section may comprise at least one groove feature and/or comprise at least one ridge feature. The cross-sections as described may be combined. For example, a non-circular cross-section may be a convex polygon shape which is a polygonal approximation of a circular shape. The same cross-section may comprise a ridge feature. Other combinations are possible as desired. The cross-section may also comprise a marking. A marking may allow easy alignment during assembly. In addition or alternatively, the cross-section may be a rectangular with a groove feature, for example a square with a groove feature. The groove feature may be a notch. The cross section may also be asymmetrical, for example an asymmetric octagon. Other asymmetric variations of the aforementioned cross-sections are possible, for example asymmetric elliptical shape etc. As a further example, an asymmetric polygonal approximation of a circular shape is also possible, for example by distorting a symmetric shape to obtain an asymmetric shape.

First and/or second orientation may be defined as a respective orientation vector, for example as locally defined vectors along the length of the cable. The first and/or second orientation vector may be a normalized vector. The first orientation may be a geometric orientation of the multiple layers of superconductor material, for example a normal orientation. The second orientation may be determined by at least one reference point of the cross-section. For example, if the cross-section has a symmetry, for example a mirror symmetry, the second orientation may be determined by a vector along the symmetry axis. In some embodiments, the second orientation is determined by a vector between a center of the cross-section as a first reference point and a second reference point on the cross-section. The second reference point can be an edge of a polygonal shape or at the intersection of the cross-section and a reference axis, for example a reference axis determined by a symmetry of the cross-section. In one example, the second orientation is determined by a minor axis of a cross-section having an elliptical shape.

A circular cross-section commonly found in cables makes mechanical alignment difficult. Therefore, cross-sections as discussed above can facilitate mechanical alignment of the cable, for example during winding of the non-planar magnetic field coil or for securing the cable in place after winding, for example when electromagnetic forces act on the cable due to changing external conditions or as the current within the cable is increased or decreased.

In some embodiments, for a plurality of positions along the length of the cable, the first orientation is chosen based on one or more of the following: a magnetic field of the stellarator, a magnetic field of at least one further magnetic field coil of the stellarator, a magnetic field of one winding of the windings of the cable, a geometry of the non-planar magnetic field coil, a magnetic orientation of the multiple layers of superconductor material. Choosing the first orientation according to one or more of the factors mentioned above may have the advantage, that the critical current of the multiple layers of superconductor materials may be optimized.. Using the knowledge for example of the magnetic field of the stellarator can be used to optimize on a global scale for the entire stellarator. In most cases, the cables are optimized based on the entire magnetic field of the stellarator. In some examples, the optimization may be limited to parts of the stellarator to reduce computational load. In any case, either along the length of all cables at the same time or iteratively for cable segments or for single elements or a combination of those approaches, at a specific position along the length of the cable an optimum magnetic orientation for the multiple layers of superconductor material may be determined. As the relationship between the magnetic orientation and the first orientation may be known, an optimum first orientation can be determined in addition or alternatively.

The effect of further magnetic field coils of the stellarator may be the most significant contribution to the magnetic field at the position of the multiple layers of superconductor materials. In some cases, computational costs of optimization should be reduced. In those cases, the analysis of an optimized first orientation and/or magnetic orientation may be simplified by limiting the number of further magnetic field coils taken into account when choosing the first orientation.

Choosing the first orientation based on one or more of the factors mentioned above may allow a favorable alignment of the multiple layers of superconductor material. As properties like the critical current that the multiple layers of superconductor material can sustain depend on the magnetic field at the first orientation, taking into account the above factors allows for optimum use of the multiple layers of superconductor material. For example, if the magnetic field of the stellarator is taken into account when determining the first orientation along the length of the cable, the first orientation may be chosen so that the first orientation is always or at least in an optimized manner aligned with the magnetic field of the stellarator at the position of the cable. An optimized alignment thus may improve reliability of the non-planar magnetic field coil and may result in reduced costs of the non-planar magnetic field coil as less superconductor material may be required for an optimized first orientation compared to a fixed or non-optimized alignment of the first orientation.

In some embodiments, the outer section further comprises a conductive or non-conductive jacket portion.

A jacket portion may allow improved mechanical properties and may extend the lifetime of the cable. Further, a conductive jacket portion may provide improved electrical properties of the outer section.

At least one layer of the multiple layers of superconductor material may have a width as follows, for example, at least 10%, for example at least 25%, for example at least 50%, for example at least 75%, for example at least 90%, for example 100% of the multiple layers of superconductor material may have a width as follows: between 0.1 mm and 12 mm, between 1.2 mm and 10.8 mm, between 2.4 mm and 9.6 mm, between 3.6 mm and 8,4 mm, between 4,8 mm and 7.2 mm, 6 mm.

At least one layer of the multiple layers of superconductor material may have a width as follows, for example at least 10%, for example at least 25%, for example at least 50%, for example at least 75%, for example at least 90%, for example 100% of the multiple layers of superconductor material may have a width as follows: between 0 mm and 24 mm, between 2.4 mm and 21.6 mm, between 4.8 mm and 19.2 mm, between 7.2 mm and 16.8 mm, between 9.6 mm and 14.4 mm, 12 mm.

The multiple layers of superconductor material may comprise a number of layers based on the width of the multiple layers of superconductor material so that a stacking of the multiple layers of superconductor materials has a roughly square shape in a cross-section of the stacking of the multiple layers of superconductor material. The multiple layers of superconductor material may have a roughly plus-sign shape and/or a cross-like shape in a cross-section of the multiple layers of superconductor material.

The multiple layers of superconductor material may comprise one of the following number of layers: between 2 and 55, between 15 and 45, between 25 and 35, 30.

The multiple layers of superconductor material may comprise one of the following number of layers: between 125 and 175, between 135 and 165, between 145 and 155, 150.

The multiple layers of superconductor material may comprise one of the following number of layers: between 2 and 200 , between 40 and 160 , between 80 and 120.

In some embodiments the multiple layers of superconductor material are a high temperature superconductor tape stack.

For example, the high temperature superconductor tape stack may be a rare earth barium copper oxide superconductor, ReBCO, tape stack.

In some embodiments, the inner section comprises second conductive material which mechanically and/or electrically connects the multiple layers of superconductor material.

Using a second conductive material may have the advantage that the second conductive material can be selected optimized for the requirements of mechanically and/or electrically connecting the multiple layers of superconductor materials. For example, the second conductive material may provide high thermal and/or electrical conductivity and/or elasticity to avoid forming of cracks during cycling of current and/or thermal cycling in the multiple layers of superconductor materials. The first conductive material may be selected to optimize other properties, for example an increased stiffness compared to the second conductive material. The use of first and/or second conductive material allows the multiple layers of superconductor material to share current between the multiple layers of superconductor material. For example, if a single layer of the multiple layers of superconductor material decreases in performance, the first and/or second conductive material may allow the current to flow via the remaining layers of the multiple layers of superconductor material. Using a second conductive material may simplify manufacturing, for example by pre-connecting the multiple layers of superconductor material before forming the outer section.

In some embodiments, the first conductive material is a solder material.

In some embodiments, the second conductive material is a solder material.

Using a solder material as the first and/or second conductive material may have the advantage that manufacturing is simplified. For example, the first and/or second solder material may be added in a liquid state/or and have advantageous wetting properties. The first and/or second solder material may be a low temperature solder material. The melting temperature of the solder material may be chosen to be as high as possible but low enough so that the multiple layers of superconductor material are not adversely affected by the soldering process. The solder material may comprise lead and/or tin. For example, the solder material may be a solder with 60 weight-% lead and 40 weight-% tin. For example, ASTM B 32 Grade Sn60 may be used as a solder material with properties available at https://www.matweb.com/search/datasheet_print.aspx?matguid=06a31d97bb734b50 9043d81cf131b280.

The first and/or the second solder material may be applied by various means, for example impregnation under pressure (VPI), submersion into a bath, use of pre-soldered multiple layers of superconductor material that are treated with heat to melt the solder, but other means may be used as well or in addition.

The first and/or second solder material may be the same solder material but be applied subsequently. For example, the first solder material may be applied first and solidified. Subsequently, the second solder material may be applied and solidified. This may also be done the other way around by first applying the second solder material and subsequently applying the first solder material.

In another embodiment, a method for providing a cable with a length for a non-planar magnetic field coil in a stellarator is provided. The method comprises: a step of providing multiple layers of superconductor material.

The method further comprises a step of orienting the multiple layers of superconductor material in a plurality of positions along the length of the cable with a plurality of first orientations.

The method further comprises a step of providing a first conductive material to fix the plurality of first orientations.

The method may be carried out as a continuous method, which may allow manufacturing in an efficient and simplified manner compared to manual cable production.

The step of orienting may further comprise: changing a first twist angle of a guiding element while moving the multiple layers of superconductor material through the guiding element to control the plurality of first orientations.

Changing a first twist angle of a guiding element while moving the multiple layers of superconductor material may allow to control the plurality of first orientations in a continuous manner along the length of the cable. This may allow a reduced strain on the multiple layers of superconductor material while at the same time allowing optimization of the first orientation.

In some embodiments, the method further comprises: a step of forming an outer section with a cross-section, the outer section comprising the first conductive material and the outer section surrounding the multiple layers of superconductor material.

Forming an outer section with a cross-section may facilitate mechanical alignment of the cable.

The step of forming the outer section may further comprise: controlling a plurality of second orientations of the cross-section along the length of the cable independently from the plurality of first orientations.

Controlling the plurality of second orientations along the length of the cable independently from the plurality of first orientations may allow to optimize the first orientation as desired, for example based on a magnetic field of the stellarator. Independently, the second orientation may be optimized according to different criteria, for example to facilitate winding of the non-planar magnetic field coil or in accordance with mechanical requirements of the non-planar magnetic field coil.

The outer cross-section may be one or more of the following: non-circular, rectangular, square, hexagonal, octagonal, polygonal, a polygonal approximation of a circular shape, a polygonal approximation of an elliptical shape, an equiangular polygon, an equilateral polygon, a regular polygon, a convex polygon. The outer cross-section may alternatively or in addition be one of the following: a polygon with the following number of sides: between 3 and 100, between 3 and 50, between 3 and 64, between 3 and 32, between 4 and 16, between 4 and 12, 3, 4, 5, 6, 7, 8, 9, 10, 11, 12; comprising at least one groove feature, comprising at least one ridge feature.

As discussed, the above cross-sections may facilitate mechanical alignment of the cable.

The step of forming the outer section may further comprise: providing a jacket portion, wherein the jacket portion is conductive or non-conductive. As discussed, a jacket portion may allow improved mechanical properties and/or electrical properties of the outer section.

In some embodiments of the method, the plurality of first orientations is chosen based on one or more of the following: a magnetic field of the stellarator, a magnetic field of at least one further magnetic field coil of the stellarator, a magnetic field of one winding of the cable in the magnetic field coil, a geometry of the non-planar magnetic field coil, a preferential alignment direction of the multiple layers of superconductor material.

As discussed, choosing the first orientation based on one or more of the factors mentioned above allows a favorable alignment of the multiple layers of superconductor material and may allow for optimum use of the multiple layers of superconductor material.

The step of providing first conductive material may comprise providing solder material in a liquid state.

Providing solder material in a liquid state may have the advantage that the liquid solder material is wetting and thus no or few cavities are created in the manufacturing step.

### BRIEF DESCRIPTION OF THE DRAWINGS

Fig. 1 shows a schematic view of a stellarator.
Fig. 2a and Fig. 2b show different examples of multiple layers of superconductor material.
Fig. 3 shows an example of the critical current as a function of an angle of a magnetic field.
Fig. 4 shows an exemplary winding in a non-planar magnetic field coil of a stellarator.
Fig. 5 shows a schematic representation of a section of a cable.
Fig. 6a, Fig. 6b, and Fig. 6c show cross-sectional views of a cable at different positions along the length of the cable.
Fig. 7a, Fig. 7b, Fig. 7c, and Fig. 7d show additional examples of a cable.
Fig. 8a and Fig. 8b show example cross-sections of a cable.
Fig. 9a, Fig. 9b, 9c, and Fig. 9d show examples in which the orientation along the length of the cable is determined by a first twist angle.
Fig. 10 shows some alternative features of a cable.
Fig. 11 shows a method for providing a cable.
Fig. 12a shows an exemplary manufacturing device to carry out the steps of the method for providing a cable.
Fig. 12b and Fig. 12c show a guiding element at different times while carrying out the method for providing a cable.

### DETAILED DESCRIPTION

In the following, a detailed description with reference to the figures is provided. In the figures, identical reference signs refer to identical elements. Examples for cables are shown.

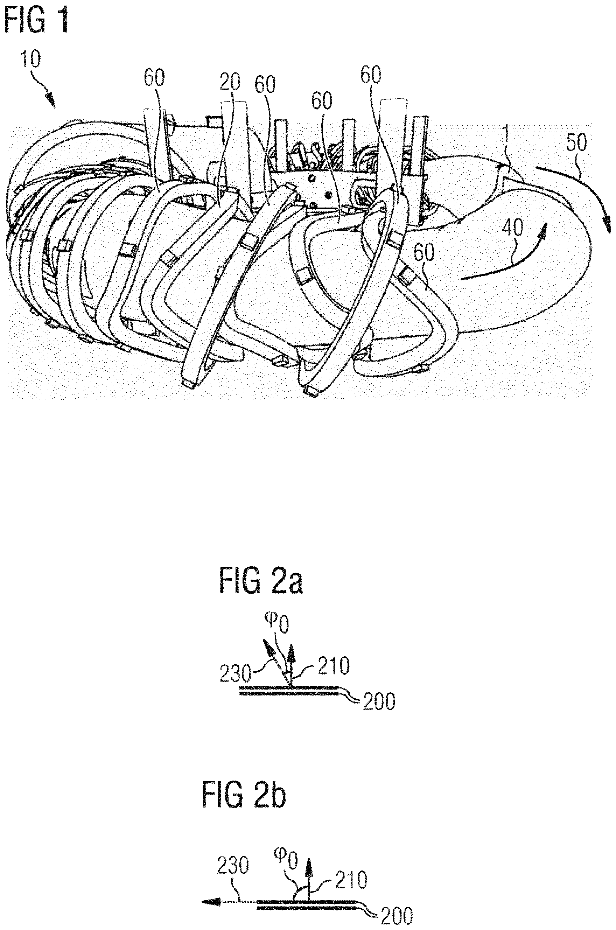

Fig. 1 shows a schematic view of a stellarator. Some elements are removed for clarity. In Fig. 1, a stellarator 10 is shown for magnetic confinement of a plasma 1. Inside the plasma 1, nuclear fusion reactions occur and release energy. The required magnetic confinement of the plasma 1 in stellarator 10 is achieved by a magnetic field coil 20 and further magnetic field coils 60 as well as additional magnetic field coils shown in Fig. 1 without reference numerals.

Fig. 2a and Fig. 2b show different examples of multiple layers of superconductor material. The multiple layers of superconductor material 200 may be part of a high-temperature superconductor tape stack. In Fig. 2a and Fig. 2b two layers of superconductor material 200 are shown for illustrative purposes, but also a single layer or a larger amount of layers is possible. Each of the layers of superconductor material 200 may be comparatively thin, for example on the order of 3-5 µm and have a width of 12 mm while extending in the direction perpendicular to the cross-section shown in Fig. 2a and Fig. 2b at an arbitrary length for example 6 m. However, in other examples other dimensions are possible. The layers of superconductor material 200 may have a first orientation 210. The first orientation 210 may be a geometric orientation of the multiple layers of superconductor material 200, for example a normal orientation.

The multiple layers of superconductor material 200 may comprise rare earth barium copper oxide superconductor, ReBCO, tapes.

Due to material properties, for example material composition and/or crystal orientation, the multiple layers of superconductor material 200 may have a magnetic orientation 230. As shown in Fig. 2a and Fig. 2b, the magnetic orientation 230 may be different from the first orientation 210. In the example of Fig. 2a, the magnetic orientation 230 is at an angle φₒ=30° with respect to the first orientation 210. In the example of Fig. 2b, the magnetic orientation 230 is at an angle φₒ=90° with respect to the first orientation 210. However, other relationships between the magnetic orientation 230 and the first orientation 210 are possible, for example due to different definitions of first orientation 210 and/or magnetic orientation 230. Further, different manufacturing techniques and/or material systems used for the multiple layers of superconductor material 200 may result in different relationships between the first orientation 210 and the magnetic orientation 230.

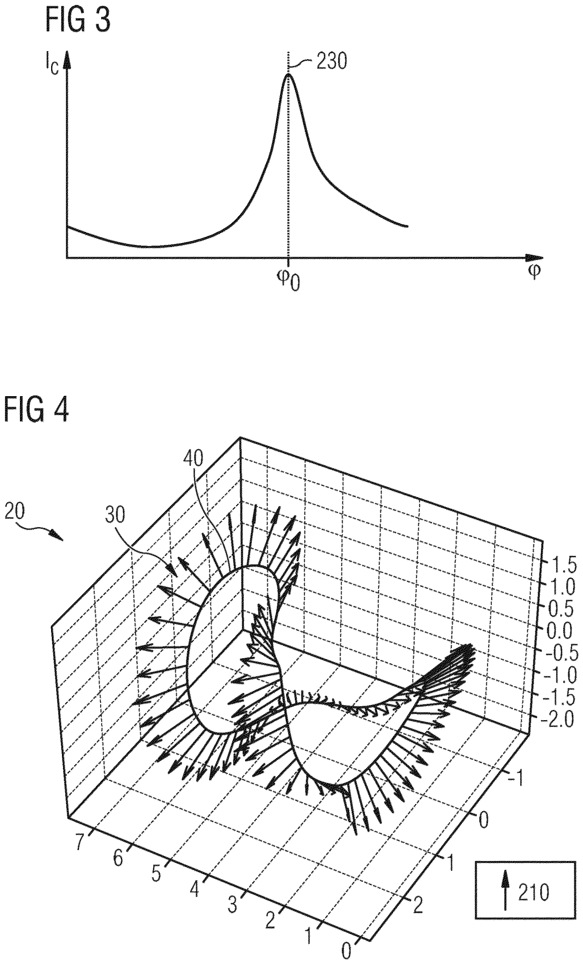

The graph in Fig. 3 shows the critical current, I_{c}, that multiple layers of superconductor material can conduct without losing the superconducting state for a given temperature as a function of an angle φ between the first orientation of the multiple layers of superconductor material and an external magnetic field. As can be seen from Fig. 3, the highest value of I_{c} is achieved for the angle φₒ which corresponds to the magnetic orientation 230 of multiple layers of superconductor material 200. In the example of Fig. 2a the highest value of I_{c} is achieved at φₒ=30° and in the example of Fig. 2b the highest value of I_{c} is achieved at φₒ=90°.

Fig. 4 shows an exemplary winding in a non-planar magnetic field coil of a stellarator. The cable 40 in Fig. 4 is shown as a closed loop for illustrative purposes. Some cables, for example cables which are part of windings in a non-planar magnetic field coil may be similar in shape to cable 40 shown in Fig. 4. However, some cables which are part of windings in a non-planar magnetic field coil may not be a closed loop, for example such cables may have the shape of an open loop with the open loop connecting to a next winding not shown in Fig. 4. However, the principles discussed with reference to Fig. 4 and other figures may also apply to these cables and other cables. In Fig. 4, winding 30 of cable 40 is part of a non-planar magnetic field coil 20. The non-planar magnetic field coil may be one of the non-planar magnetic field coils 20, 60 shown in Fig. 1. In a stellarator, the magnetic field at each location is determined by the physical requirements of the stellarator. Therefore, based on the properties of the multiple layers of superconductor materials as discussed with respect to Fig. 2a, Fig. 2b, and Fig. 3, for each position of the winding an optimum first orientation 210 can be determined. In Fig. 3, the optimum first orientation 210 is indicated by arrows for a plurality of positions along a length of the cable 40.

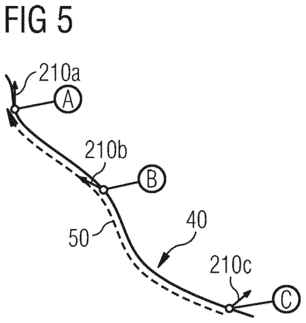

The cable 40 shown in Fig. 5 may be a section of the cable 40 shown in Fig. 4. Fig. 5 shows that for a plurality of positions A, B, C along the length 50 of the cable 40, the first orientation 210a, 210b, 210c is chosen. As discussed above with respect to Fig. 2a, Fig. 2, Fig. 3, and Fig. 4, the orientation can be chosen based on requirements of the stellarator, for example a magnetic field of the stellarator 10, a magnetic field of at least one further magnetic field coil 60 of the stellarator 10, a magnetic field of one winding of the windings of the cable, a geometry of the non-planar magnetic field coil 20, a magnetic orientation 230 of the multiple layers of superconductor material 200.

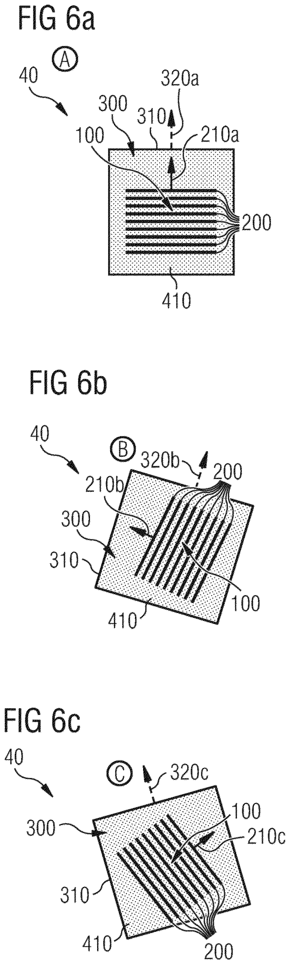

Fig. 6a, Fig. 6b, and Fig. 6c show cross-sectional views of a cable at different positions along the length of the cable. Fig. 6a shows a cross-section of cable 40 at a position A, Fig. 6b shows a cross-section of cable 40 at a position B. As an additional example, Fig. 6c shows a cross-section of cable 40 at a position C. The positions A, B, C may correspond to the positions A, B, C shown in Fig. 5 or different.

Describing Fig. 6a, the cable 40 may be part of a stellarator 10, comprising a non-planar magnetic field coil 20 including windings 30 of the cable 40. The cable 40 comprises an inner section 100. The inner section 100 comprises multiple layers of superconductor material 200, the multiple layers of superconductor material 200 having a first orientation 210a. The cable 40 further comprises an outer section 300 surrounding the inner section 100, the outer section 300 having a cross-section 310 with a second orientation 320a. The outer section 300 comprises a first conductive material 410 which fixes the first orientation 210a.

Fig. 6b corresponds to Fig. 6a. Different from Fig. 6a, Fig. 6b is at position B of the cable 40. At position B the first orientation 210b of the multiple layers of superconducting material 200 is different from the first orientation 210a shown in Fig. 6a. Position B shown in Fig. 6b may be position B shown in Fig. 5. In the example of Fig. 6b, the second orientation 320b of the cross-section 310 of the outer section 300 is also different from the second orientation 320a shown in Fig. 6a.

In the example shown with Fig. 6a and Fig. 6b both the first and the second orientation changes along a length of the cable. In this example, the length of the cable is the length of the cable between position A shown in Fig. 6a and position B shown in Fig. 6b. In other examples, only the first or the second orientation changes along a length of the cable. There may also be parts along the length of the cable where neither the first nor the second orientation changes along the length of the cable.

Fig. 6c shows a further example. Fig. 6c corresponds to Fig. 6a. The cross-sectional view shown in Fig. 6c is at a position C. At position C, the first orientation 210c of the multiple layers of superconducting material 200 is different from the first orientation 210a shown in Fig. 6a and also different from the first orientation 210b shown in Fig. 6b. Position C of Fig. 6c may be position C shown in Fig. 5. In the example of Fig. 6c, the second orientation 320c of the cross-section 310 of the outer section 300 is also different from the second orientation 320a shown in Fig. 6a and from the second orientation 320b shown in Fig. 6b.

In summary, Fig. 6a, Fig. 6b, and Fig. 6c show examples of how the first orientation 210a, 210b, and 210c shown in Fig. 6a, Fig. 6b, and Fig. 6c, respectively, changes along a length 50 of the cable 40 with respect to the second orientation 320a, 320b, 320c shown in Fig. 6a, Fig. 6b, and Fig. 6c, respectively. Thereby, the cable 40 allows for an optimization of the first orientation 210a, 210b, 210c while at the same time the cable 40 allows for an optimization of the second orientation 320a, 320b, 320c. Notably, independent variation and thus independent optimization of the first orientation and second orientation may be possible.

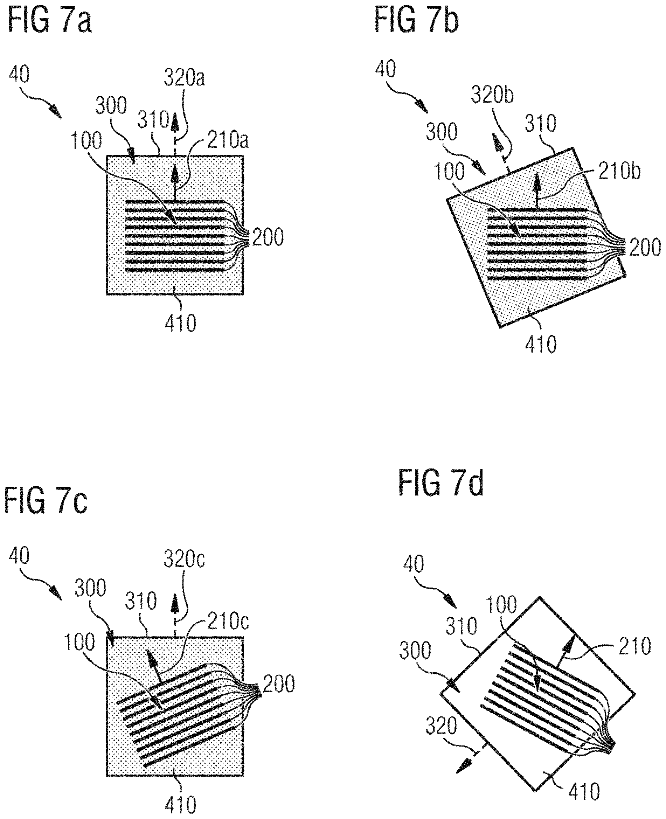

Fig. 7a, Fig. 7b, Fig. 7c, and Fig. 7d show additional examples of a cable. In the examples of Fig. 7a and Fig. 7b the second orientation 320a of the cross-section changes along a length of the cable 40, wherein the length is between the position of the cable 40 shown in Fig. 7a and the different position of the cable 40 shown in Fig. 7b. Fig. 7a shows a cross-sectional view of the cable at a first position, for example position A in Fig. 5. In the example of Fig. 7a, the first orientation 210a and the second orientation 320a are aligned.

Fig. 7b shows a cross-sectional view of the cable at a second position. The second position is different from the first position. At the second position, the second orientation 320b is different from the first orientation 210b. Further, the second orientation 320b is the same as the second orientation 320a in the first position as shown in Fig. 7a. Thus, the example of Fig. 7a and Fig. 7b shows a possibility how the first orientation, namely first orientation 210a at the first position A and first orientation 210b at the second position B, changes along a length of the cable with respect to the second orientation, namely second orientation 320a at the first position A and second orientation 320b at the second position B.

Fig. 7c shows a cross-sectional view of the cable at another position, for example a third position of the cable described with respect to Fig. 7a and 7b. In a different example, Fig. 7c could be at the second position described previously with respect to Fig. 7b or an entirely different position along the length of the cable.

In the cross-sectional position shown in Fig. 7c, the first orientation 210c is changed with respect to the first orientation 210a shown in Fig. 7a, while the second orientation 320c of Fig. 7c is identical to the second orientation 320a of Fig. 7a. Thus, the invention allows to optimize the first orientation 210a, 210b, 210c independent from the second orientation 320a, 320b, 320c at each of the plurality of positions A, B, C.

Fig. 7d shows a further alternative at a different position. In the example of Fig. 7d, the first orientation 320 and second orientation 210 are chosen independently of each other. When combined with at least one of the examples of Fig. 7a, Fig. 7b, and Fig. 7c, this allows to optimize both the first orientation and the second orientation independently from each other. Namely, the first orientation can be optimized with respect to requirements, for example requirements of the magnetic orientation 230 discussed above with respect to Fig. 2a, Fig. 2b, and Fig. 3.

Independently, the second orientation 320 of the cross-section 310 can be optimized, for example based on requirements for mechanical alignment and manufacturing of the non-planar magnetic field coil 20 shown in Fig. 1. In some examples, this allows both to optimize the mechanical manufacturing of the windings 30 of the cable 40 and/or the optimization of the first orientation and/or the second orientation. For example, the optimization may be based one of the following: a magnetic field of the stellarator 10, a magnetic field of at least one further magnetic field coil 60 of the stellarator 10, a magnetic field of one winding of the windings of the cable, a geometry of the non-planar magnetic field coil 20, a magnetic orientation 230 of the multiple layers of superconductor material 200.

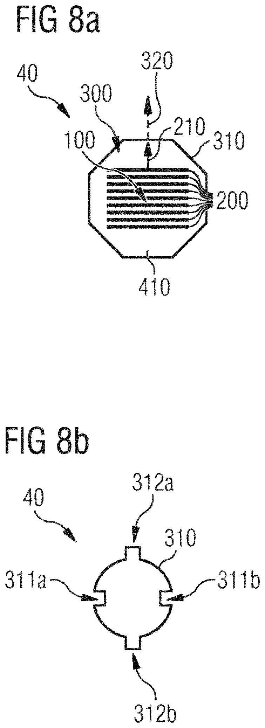

Fig. 8a and Fig. 8b show example cross-sections 310 of a cable 40. In the above examples, for example in Fig. 6a, the cross-section 310 of the outer section 300 was shown as a square shape. However, the cross-section may take any shape that enables mechanical alignment of the second orientation. As a first example, Fig. 8a shows an octagonal cross-section 310.

Fig. 8b shows an essentially circular cross-section that comprises two groove features 311a and 311b and two ridge features 312a and 312b. While in the example of Fig. 8b two ridge features and two groove features are shown, any number of ridge features and/or groove features is possible. In other examples, at least one ridge feature and/or at least one groove feature is present, for example ridge feature 312a and/or groove feature 311a.

In the example shown, the groove and ridge features have a rectangular shape, but any shape that enables mechanical alignment is possible. In some examples the cross-section 310 remains identical along the length of the cable 40. In other examples, the cross-section 310 changes along the length of the cable. For example, a cable may have a groove feature and/or a ridge feature periodically or randomly located along the length of the cable. As another example, which can be in combination with the previous example, the cross-section 310 may change from a first cross-section at a first position to a second cross-section at a second position. For example, at a first position the cross-section may be square and at a second position the cross-section may be elliptical. Other combinations of cross-sections are possible.

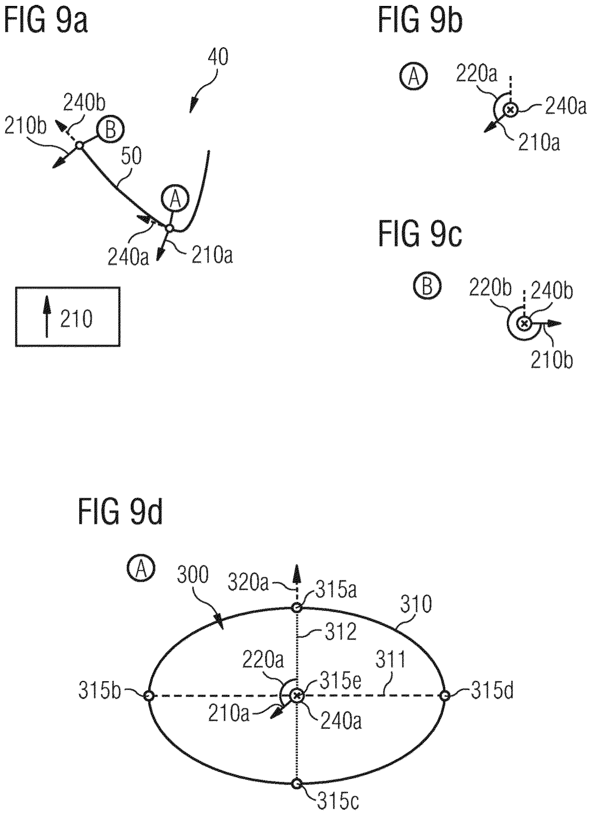

Fig. 9a, Fig. 9b, 9c, and Fig. 9d show examples in which the first orientation along the length of the cable is determined by a first twist angle. Fig. 9a shows another example of a cable 40 wherein a first orientation 210 changes along a length 50 of the cable 40. Fig. 9 shows two examples for first orientation 210, namely a first orientation 210a at a first position A and a second orientation 210b at a second position B. At positions A and B, a direction 240a, 240b along the length 50 of the cable 40 is exemplarily shown.

Fig. 9b shows that the first orientation 210a shown at position A is determined by a first twist angle 220a defined perpendicular to the direction 240a shown in Fig. 9a and into the plane of the figure (denoted by the cross-symbol) in Fig. 9b. Fig. 9b corresponds to Fig. 9a. Fig 9b shows that the first orientation 210b at position B is determined by a first twist angle 220b defined perpendicular to the direction 240b. Similarly, Fig. 9c shows the first orientation 210b at position B, which is now determined by a first twist angle 240b. Note that in position B the first twist angle 240b is different from the first twist angle 240a in position A shown in Fig. 9b. Positions A and B are shown as examples. The first twist angle can be continuously defined along the length 50. This allows manufacturing the cable 50 in a continuous manufacturing process while controlling the plurality of first orientations as will be explained further elsewhere.

Fig. 9d shows an example how the second orientation may be determined. The second orientation may be determined in a similar manner to the first orientation. Fig. 9d shows an example at the position A shown in Fig. 9a. In the example of Fig 9d, the cross-section 310 of the outer section 300 has an elliptical shape with a mayor axis 311 and a minor axis 312. The intersection of minor axis 312 and cross-section 310 may define reference points on the cross-section, for example reference point 315a and reference point 315c. Likewise, the intersection of major axis 311 and cross-section 310 may define reference point 315b and reference point 315d. The intersection of mayor axis 311 and minor axis 312 may define reference point 315e. Reference point 315e is located in the center of the cross-section. In other examples, a reference point located in the center of the cross-section may be determined. a reference point located in the center of the cross-section may be determined in examples in which the cross-section has no symmetry. In Fig. 9d, an elliptical cross-section 310 is shown, but using a single axis of symmetry and/or several axes of symmetry to define reference points as illustrated in Fig. 9d may be used for other shapes as well, for example for polygonal cross-sections which may have a rotational symmetry. In the example of Fig. 9d, the second orientation 320a is determined by a vector between reference point 315e which is located in the center of the cross-section 310 and reference point 315a, resulting in a second orientation 320a at position A. As illustrated in Fig. 9d for the example of position A, the second orientation may be defined as a normalized vector for a plurality of positions along the length of the cable in a consistent manner. In the example of the elliptical cross-section 310 shown in Fig. 9d, a consistent manner along the length of the cable could be to always define the second orientation between the center of the ellipse, 315e in Fig. 9d, and a reference point as reference point 315a constructed in Fig. 9d. While in Fig. 9d 315e and 315a were used to define the second orientation 320a, in other examples the second orientation may be defined otherwise, for example along the major axis 311, for example using reference points 315b and 315d. In this case, at other positions along the length of the cable, the same way of determining the second orientation can be used.

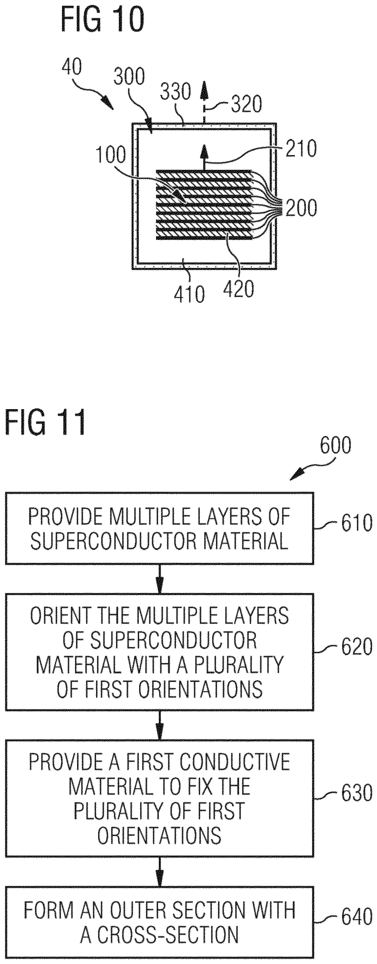

Fig. 10 shows some alternative features of a cable 40. Different from the example of Fig. 6a, the cable 40 in Fig. 10, in particular the outer section 300 of the cable 40 comprises a jacket portion 330. The jacket portion 330 may be conductive or non-conductive. In the example of Fig. 10 the jacket portion is shown as a single-piece element, but the jacket portion may also be made from several parts. In Fig. 10 the jacket portion 330 is shown to enclose the entire outer section. However, the jacket portion may also only partially cover the outer section 330, for example only a single side, the top half, the bottom half, a corner, etc.

In the example of Fig. 10, the inner section 100 comprises a second conductive material 420. The second conductive material 420 may mechanically and/or electrically connect the multiple layers of superconductor material 200. These elements shown in Fig. 10 are optional. For example, a cable may comprise a second conductive material 420 but not a jacket portion 330 or it may comprise a jacket portion 330 but not a second conductive material 420. In the latter case, instead of the second conductive material 420 the first conductive material 410 may also extend between the multiple layers of superconductor material 200, as for example shown in Fig. 6a.

Fig. 11 shows a method 600 for providing a cable 40 with a length 50 for a non-planar magnetic field coil 20 in a stellarator 10. The cable 40 may be the cable as shown in the previous figures and the stellarator may be the stellarator shown in Fig. 1. The method 600 comprises:

In step 610 multiple layers of superconductor material 200 are provided. Each of the multiple layers of superconductor material 200 may include additional layers. For example, the multiple layers of superconductor material 200 may each be made from rare earth barium copper oxide superconductor, ReBCO, tapes.

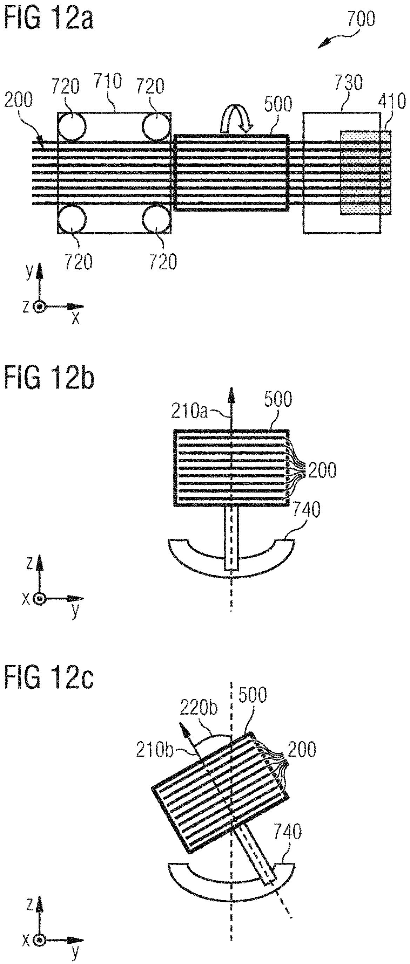

In step 620, the multiple layers of superconductor material 200 are oriented in a plurality of positions A, B, C along the length 50 of the cable with a plurality of first orientations, for example plurality of first orientations 210a, 210b, and 210c as shown in Fig. 5. The orientation may be determined by a first twist angle 220, for example with first twist angles 22a and 220b at positions A and B, respectively, as explained with respect to Fig. 9a to Fig. 9c above. Examples how the orientation may be achieved are explained with respect to Fig. 12a to Fig. 12c below.

In step 630 a first conductive material 410 is provided to fix the plurality of first orientations, for example the first orientations 210a, 210b, and/or 210c shown in the figures above.

In optional step 640 an outer section 300 with a cross-section 310 is formed, the outer section 300 comprising the first conductive material 410 and the outer section 300 surrounding the multiple layers of superconductor material 200.

The method described in Fig. 11 allows manufacturing of a cable 40 as shown in the above figures, for example Fig. 6a to Fig. 6c, Fig. 7a to Fig. 7c, or Fig. 8a and Fig. 8b.

Fig. 12a shows an exemplary manufacturing device 700 to carry out the steps of the method 600 shown in Fig. 11 for providing a cable.

Manufacturing device 700 may carry out the steps of method 600 described previously. Multiple layers of superconductor material 200 are provided by a feeding element 710. In Fig. 12a the multiple layers of superconductor material 200 are provided continuously in positive x-direction. The movement is achieved by rollers 720. The rollers 720 may be spring-loaded. Feeding element 710 provides the multiple layers of superconductor material 200 to a guiding element 500. The guiding element 500 orients the multiple layers of superconductor material 200 in a plurality of positions along the length 50 of the cable with a plurality of first orientations.

As will be explained with reference to Fig. 12b and Fig. 12c below, guiding element 500 may control the plurality of orientations via a first twist angle. Other ways to control the plurality of orientations are possible, for example using rollers, slides, for example slides with teflon or using other means known in the art. After the step of orienting, the plurality of superconductor materials is moved to fixing element 730. Fixing element 730 provides a first conductive material 410 to fix the plurality of first orientations. The step of fixing element 730 providing the first conductive material may comprise providing solder material in a liquid state by fixing element 730. Fixing element 730 may also form an outer section 300 with a cross-section 310 as for example shown in Fig. 6a. In addition, fixing element 730 may provide a conductive or non-conductive jacket portion 330 as shown in Fig. 10.

By performing the method of Fig. 11, manufacturing device 700 provides a cable which may be used in a stellarator.

Fig. 12b and Fig. 12c are detailed views of guiding element 500 at different times while carrying out the method for providing a cable. Guiding element 500 may be part of the manufacturing device 700 shown in Fig. 12a. As shown by the coordinate systems in Fig. 12a, Fig. 12b, and Fig. 12c, the multiple layers of superconductor material 200 move along the x-axis towards the viewer out of the plane of Fig. 12b and Fig. 12c. Guiding element 500 may control a first twist angle 220 as explained with reference to Fig. 9b and Fig. 9c. At a first point in time, Tₐ shown in Fig. 12b, a first position of the superconductor material 200 may be inside guiding element 500 and the first twist angle of guiding element 500 may be controlled so that the multiple layers of superconductor material 200 have a first orientation 210.

Fig. 12c shows a second point in time, T_{b}. The multiple layers of superconductor material 200 may have moved further along the length of the cable in the x-direction and therefore a second position along the length of the cable may be now at guiding element 500. Using movement element 740 which may be a computer-controlled servo, the first twist angle 220b of guiding element 500 may be changed. The change of the first twist angle 220b may change the first twist angle 220b of the multiple layers of superconductor material 200. Movement element 740 may thus change the first twist angle of a guiding element 500 while multiple layers of superconductor material 200 are moved through the guiding element 500. Thereby, guiding element 500 may control the plurality of first orientations, for example first orientation 210a and first orientation 210b.

It should be noted that groups of figures are discussed together to explain the concept of the invention at different locations of the cable. However, it is also possible to combine various aspects described of the examples. For example, the cross-sections shown may be varied for the cables, either for the entirety of the cable or on some parts of the cable. For example, the cross-sections shown in Fig. 8a and Fig. 8b can also be used with the other cables described, for example the cables shown in Fig. 6a, Fig. 6b, and Fig. 6c and/or the other cables described here. Also, other cross-sections can be used. It is also possible that a cable has different cross-sections at different positions along the length of the cable. For example, in Fig. 10 a second conductive material 420 was described. It is also possible, that the second conductive material 420 is used in a similar manner in the other examples, for example in the cables shown in Fig. 6a, Fig. 6b, and Fig. 6c and/or the other figures discussed above.

The above invention has been described with focus on use of the described cables in stellarator. However, the concepts described above may be used in other context, for example as cables and methods for the manufacturing thereof. For example, the invention described above may also be useful in other fields , for example with unusual geometries and hence requiring complex field alignment. In some examples, particle accelerator magnets or magnetic resonance tomography may use the cables disclosed here. This will be detailed below with the further examples.

### FURTHER EXAMPLES

Example 1. A cable (40) comprising: an inner section (100) comprising multiple layers of superconductor material (200), the multiple layers of superconductor material (200) having a first orientation (210, 210a, 210b, 210c), an outer section (300) surrounding the inner section (100), the outer section (300) having a cross-section (310) with a second orientation (320, 320a, 320b, 320c), wherein the outer section (300) comprises a first conductive material (410) which fixes the first orientation (210, 210a, 210b, 210c), wherein the first orientation (210, 210a, 210b, 210c) changes along a length (50) of the cable (40) with respect to the second orientation (320, 320a, 320b, 320c).

Example 2. The cable of example 1, wherein the first orientation (210, 210a, 210b, 210c) along the length (50) of the cable (40) is determined by a first twist angle (220a, 220b, 220c) defined perpendicular to a direction (240a, 240b, 240c) along the length (50) of the cable (40).

Example 3. The cable of one of the previous examples, wherein the cross-section (310) enables mechanical alignment of the second orientation (320, 320a, 320b, 320c) and wherein the cross-section (310) is one or more of the following:
non-circular,
rectangular,
square,
hexagonal,
octagonal,
polygonal,
a polygonal approximation of a circular shape,
a polygonal approximation of an elliptical shape,
an equiangular polygon,
an equilateral polygon,
a regular polygon,
a convex polygon,
a polygon with the following number of sides:
   between 3 and 100, between 3 and 50, between 3 and 64, between 3 and 32,
   between 4 and 16, between 4 and 12, 3, 4, 5, 6, 7, 8, 9, 10, 11, 12;
   comprising at least one groove feature,
   comprising at least one ridge feature.

Example 4. The cable of one of the previous examples, wherein for a plurality of positions (A, B, C) along the length (50) of the cable (40), the first orientation (210, 210a, 210b, 210c) is chosen based on one or more of the following:
an external magnetic field, for example of a stellarator (10),
a magnetic field of at least one further magnetic field coil, for example of a stellarator (10),
a magnetic field of one winding of the windings of the cable(40),
a geometry of the non-planar magnetic field coil (20),
a magnetic orientation (230) of the multiple layers of superconductor material (200).

Example 5. The cable of one of the previous examples, wherein the outer section (300) further comprises a conductive or non-conductive jacket portion (330).

Example 6. The cable of one of the previous examples, wherein the multiple layers of superconductor material (200) are a high temperature superconductor tape stack.

Example 7. The cable of one of the previous examples, wherein the inner section (100) comprises second conductive material (420) which mechanically and/or electrically connects the multiple layers of superconductor material (200) and/or the first conductive material (410) is a solder material and/or the second conductive material (420) is a solder material.

Example 8. A method (600) for providing a cable (40) with a length (50) comprising:
a step (610) of providing multiple layers of superconductor material (200),
a step (620) of orienting the multiple layers of superconductor material (200) in a plurality of positions (A, B, C) along the length (50) of the cable with a plurality of first orientations (210, 210a, 210b, 210c),
a step (630) of providing a first conductive material (410) to fix the plurality of first orientations (210, 210a, 210b, 210c).

Example 9. The method of example 8, the step of orienting further comprising: changing a first twist angle (220) of a guiding element (500) while moving the multiple layers of superconductor material (200) through the guiding element (500) to control the plurality of first orientations (210, 210a, 210b, 210c).

Example 10. The method of example 8 or 9, further comprising: a step (640) of forming an outer section (300) with a cross-section (310), the outer section (300) comprising the first conductive material (410) and the outer section (300) surrounding the multiple layers of superconductor material (200).

Example 11. The method of example 10, the step of forming the outer section (300) further comprising: controlling a plurality of second orientations (320, 320a, 320b, 320c) of the cross-section (310) along the length (50) of the cable independently from the plurality of first orientations (210, 210a, 210b, 210c).

Example 12. The method of example 10 or 11, wherein the cross-section (310) is one or more of the following:
non-circular,
rectangular,
square,
hexagonal,
octagonal,
polygonal,
a polygonal approximation of a circular shape,
a polygonal approximation of an elliptical shape,
an equiangular polygon,
an equilateral polygon,
a regular polygon,
a convex polygon,
a polygon with the following number of sides:
   between 3 and 100, between 3 and 50, between 3 and 64, between 3 and 32,
   between 4 and 16, between 4 and 12, 3, 4, 5, 6, 7, 8, 9, 10, 11, 12;
   comprising at least one groove feature,
   comprising at least one ridge feature.

Example 13. The method of any of examples 10 to 12, the step of forming the outer section (300) further comprising: providing a jacket portion (330), wherein the jacket portion (330) is conductive or non-conductive.

Example 14. The method of one of examples 8 to 13, wherein the plurality of first orientations (210, 210a, 210b, 210c) are chosen based on one or more of the following:
an external magnetic field,
a magnetic field of at least one further magnetic field coil, for example of a stellarator (10),
a magnetic field of one winding of the cable in the magnetic field coil (20),
a geometry of the non-planar magnetic field coil (20),
a preferential alignment direction of the multiple layers of superconductor material (200).

Example 15. The method of one of examples 8 to 14, wherein the step of providing first conductive material (410) comprises providing solder material in a liquid state.

## Claims

1. A stellarator (10), comprising:
a non-planar magnetic field coil (20) including windings (30) of a cable (40), the cable (40) comprising:
an inner section (100) comprising multiple layers of superconductor material (200), the multiple layers of superconductor material (200) having a first orientation (210, 210a, 210b, 210c),
an outer section (300) surrounding the inner section (100), the outer section (300) having a cross-section (310) with a second orientation (320, 320a, 320b, 320c), wherein the outer section (300) comprises a first conductive material (410) which fixes the first orientation (210, 210a, 210b, 210c),
wherein the first orientation (210, 210a, 210b, 210c) changes along a length (50) of the cable (40) with respect to the second orientation (320, 320a, 320b, 320c).

2. The stellarator of claim 1, wherein the first orientation (210, 210a, 210b, 210c) along the length (50) of the cable (40) is determined by a first twist angle (220a, 220b, 220c) defined perpendicular to a direction (240a, 240b, 240c) along the length (50) of the cable (40).

3. The stellarator (10) of one of the previous claims, wherein the cross-section (310) enables mechanical alignment of the second orientation (320, 320a, 320b, 320c) and wherein the cross-section (310) is one or more of the following:
non-circular,
rectangular,
square,
hexagonal,
octagonal,
polygonal,
a polygonal approximation of a circular shape,
a polygonal approximation of an elliptical shape,
an equiangular polygon,
an equilateral polygon,
a regular polygon,
a convex polygon,
a polygon with the following number of sides:
between 3 and 100, between 3 and 50, between 3 and 64, between 3 and
32, between 4 and 16, between 4 and 12, 3, 4, 5, 6, 7, 8, 9, 10, 11, 12;
comprising at least one groove feature,
comprising at least one ridge feature.

4. The stellarator (10) of one of the previous claims, wherein for a plurality of positions (A, B, C) along the length (50) of the cable (40), the first orientation (210, 210a, 210b, 210c) is chosen based on one or more of the following:
a magnetic field of the stellarator (10),
a magnetic field of at least one further magnetic field coil (60) of the stellarator (10),
a magnetic field of one winding of the windings of the cable(40),
a geometry of the non-planar magnetic field coil (20),
a magnetic orientation (230) of the multiple layers of superconductor material (200).

5. The stellarator (10) of one of the previous claims, wherein the outer section (300) further comprises a conductive or non-conductive jacket portion (330).

6. The stellarator (10) of one of the previous claims, wherein the multiple layers of superconductor material (200) are a high temperature superconductor tape stack.

7. The stellarator (10) of one of the previous claims, wherein the inner section (100) comprises second conductive material (420) which mechanically and/or electrically connects the multiple layers of superconductor material (200)
and/or
the first conductive material (410) is a solder material
and/or
the second conductive material (420) is a solder material.

8. A method (600) for providing a cable (40) with a length (50) for a non-planar magnetic field coil (20) in a stellarator (10), comprising:
a step (610) of providing multiple layers of superconductor material (200),
a step (620) of orienting the multiple layers of superconductor material (200) in a plurality of positions (A, B, C) along the length (50) of the cable with a plurality of first orientations (210, 210a, 210b, 210c),
a step (630) of providing a first conductive material (410) to fix the plurality of first orientations (210, 210a, 210b, 210C).

9. The method of claim 8, the step of orienting further comprising:
changing a first twist angle (220) of a guiding element (500) while moving the multiple layers of superconductor material (200) through the guiding element (500) to control the plurality of first orientations (210, 210a, 210b, 210C).

10. The method of claim 8 or 9, further comprising:
a step (640) of forming an outer section (300) with a cross-section (310), the outer section (300) comprising the first conductive material (410) and the outer section (300) surrounding the multiple layers of superconductor material (200).

11. The method of claim 10, the step of forming the outer section (300) further comprising:
controlling a plurality of second orientations (320, 320a, 320b, 320c) of the cross-section (310) along the length (50) of the cable independently from the plurality of first orientations (210, 210a, 210b, 210c).

12. The method of claim 10 or 11, wherein the cross-section (310) is one or more of the following:
non-circular,
rectangular,
square,
hexagonal,
octagonal,
polygonal,
a polygonal approximation of a circular shape,
a polygonal approximation of an elliptical shape,
an equiangular polygon,
an equilateral polygon,
a regular polygon,
a convex polygon,
a polygon with the following number of sides:
between 3 and 100, between 3 and 50, between 3 and 64, between 3 and
32, between 4 and 16, between 4 and 12, 3, 4, 5, 6, 7, 8, 9, 10, 11, 12;
comprising at least one groove feature,
comprising at least one ridge feature.

13. The method of any of claims 10 to 12, the step of forming the outer section (300) further comprising:
providing a jacket portion (330), wherein the jacket portion (330) is conductive or non-conductive.

14. The method of one of claims 8 to 13, wherein the plurality of first orientations (210, 210a, 210b, 210c) are chosen based on one or more of the following:
a magnetic field of the stellarator (10),
a magnetic field of at least one further magnetic field coil (20) of the stellarator (10),
a magnetic field of one winding of the cable in the magnetic field coil (20),
a geometry of the non-planar magnetic field coil (20),
a preferential alignment direction of the multiple layers of superconductor material (200).

15. The method of one of claims 8 to 14, wherein the step of providing first conductive material (410) comprises providing solder material in a liquid state.
